Europäisches Patentamt

European Patent Office

Office européen des brevets

(19)

(11) Veröffentlichungsnummer: **0 014 303**
**B1**

(12) EUROPÄISCHE PATENTSCHRIFT

(45) Veröffentlichungstag der Patentschrift:
30.04.86

(21) Anmeldenummer: 80100014.2

(22) Anmeldetag: 03.01.80

(51) Int. Cl.⁴: **H 01 L 21/90**

(54) Verfahren zum Herstellen von integrierten MOS-Schaltungen in Silizium-Gate-Technologie.

(30) Priorität: 24.01.79 DE 2902665

(43) Veröffentlichungstag der Anmeldung:
20.08.80 Patentblatt 80/17

(45) Bekanntmachung des Hinweises auf die Patenterteilung:
30.04.86 Patentblatt 86/18

(84) Benannte Vertragsstaaten:
FR GB

(56) Entgegenhaltungen:
DE - A - 2 313 106
DE - A - 2 703 013
DE - A - 2 704 626
DE - A - 2 916 364
US - A - 3 911 168

"Patents Abstracts of Japan", Band 2, Nr. 11, 26. Januar 1978 Seite 10510 E 77
IBM TECHNICAL DISCLOSURE BULLETIN, Band 20, Nr. 9, Februar 1978, New York V.J. SILVESTRI "Formation of A1203 from porous aluminium near room temperature and applications" Seiten 3714 bis 3716

(73) Patentinhaber: Siemens Aktiengesellschaft, Berlin und München Wittelsbacherplatz 2, D-8000 München 2 (DE)

(72) Erfinder: Widmann, Dietrich, Dr.,
Ludwig-Steub-Strasse 2, D-8025 Unterhaching (DE)

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

LIBER, STOCKHOLM 1986

## Beschreibung

Die vorliegende Patentanmeldung betrifft ein Verfahren zum Herstellen von integrierten n- oder p-Kanal-MOS-Schaltungen in Silizium-Gate-Technologie mit selbstjustierten Kontakten.

Bei der Herstellung hochintegrierter Halbleiterschaltungen besteht eine der wichtigsten Aufgaben darin, unter Zugrundelegung einer minimalen beherrschbaren Strukturgröße möglichst viele Komponenten (zum Beispiel Transistoren) bzw. Funktionseinheiten pro Flächeneinheit unterzubringen. Besonders störend sind dabei die inaktiven Bereiche der Schaltung, das heißt, diejenigen Bereiche, die nicht direkt zur Schaltungsfunktion beitragen. Hierzu gehören die nicht nutzbaren Bereiche an der Peripherie von Kontaktlöchern. Diese inaktiven Bereiche sind durch sogenannte Sicherheitsabstände bedingt. Zur Herstellung von MOS-Bauelementen wird heute bevorzugt die Poly-Silizium-Technologie eingesetzt. Bei dieser Technologie werden die Gate-Elektroden von Feldeffekttransistoren sowie Leiterbahnen zum Anschluß solcher Elektroden aus Poly-Silizium gebildet. Die wesentlichen Vorteile dieser Technologie bestehen gegenüber einer Technik, bei der diese Elektroden und Leiterbahnen aus Aluminium bestehen, darin, daß die störenden Gate-Source- und Gate-Drain-Überlappungskapazitäten sehr klein gehalten werden können und, daß in Gestalt des Poly-Silizium eine zusätzliche "Leiterbahn"-Ebene vorhanden ist.

Bei der n-Kanal- und auch bei der p-Kanal-Silizium- bzw. Doppel-Silizium-Gate-Technik müssen Kontaktlöcher in $SiO_2$-Schichten sowohl auf n+- bzw. p+-dotierten,einkristallinen, als auch auf n+- bzw. p+-dotierten polykristallinen Siliziumbereichen erzeugt werden. Dabei muß verhindert werden, daß ein Kontaktloch mit einem Teil seiner Fläche über den zu kontaktierenden Bereich übersteht, da andernfalls die Gefahr bestehen würde, daß die über dem Kontaktloch anzubringende metallische Leitbahn einen Kurzschluß zu einem benachbarten p- bzw. n-dotierten Bereich des einkristallinen Silizium-Grundkörpers verursacht. Im Falle eines Überstehens des Kontaktloches über eine Poly-Silizium-Struktur besteht außerdem die Gefahr, daß infolge einer Unterätzung des $SiO_2$ unter die Poly-Silizium-Struktur ein Überhang der Poly-Silizium-Struktur erzeugt wird, der zu einer Unterbrechung der darüber liegenden Leitbahn führen kann.

Um ein Überstehen von Kontaktlöchern über die zu kontaktierenden Bereiche zu verbindern, müssen sogenannte Sicherheitsabstände zwischen den Kanten des Kontaktlochs einerseits und den Kanten der dotierten Siliziumbereiche andererseits vorgesehen werden. Diese Sicherheitsabstände sind deshalb erforderlich, weil der Abstand zwischen zwei Strukturkanten aus zwei verschiedenen Strukturebenen nicht beliebig genau, sondern nur mit einer bestimmten Toleranz, die beim heutigen Stand der Technik etwa ± 2 μm beträgt, eingehalten werden kann.

In der Literatur findet man verschiedene Vorschläge, um die beschriebenen Sicherheitsabstände an der Peripherie von Kontaktlöchern überflüssig zu machen.

In der DT-OS 27 23 374 ist ein Verfahren beschrieben, bei dem mit Hilfe von Nitridschichten unter Ausnutzung ihrer oxidationshemmenden, sowie Ätzstop-Wirkung Kontaktlöcher zugelassen sind, deren Grundfläche über die zu kontaktierenden Poly-Silizium-Bereiche hinausragt. Allerdings benötigt dieses Verfahren eine zusätzliche Kontaktlochmaske; an der Peripherie der Kontaktlöcher zwischen den einkristallinen n+- bzw. p+-dotierten Bereichen und den metallischen Leitbahnen müssen nach wie vor Sicherheitsabstände vorgesehen werden und die Kontaktlochböschungen sind sehr steil oder sogar überhängend.

Nach einem weiteren Vorschlag (V. L. Rideout, J. J. Walker, A. Cramer: "A one-device memory cell using a single layer of polysilicon and a selfregistering metal-to-polysilicon contact", International Electron Devices Meeting, Technical Digest, Washington, USA, Dec. 1977, p. 258) wird die Poly-Silizium-Schicht an denjenigen Stellen, an denen Kontaktlöcher entstehen sollen, mit einer Doppelschicht aus Siliziumdioxid und Siliziummitrid bedeckt, während die übrigen Teile der gewünschten Poly-Silizium-Strukturen mit einer Siliziumdioxidschicht maskiert werden. Die nicht bedeckten Teile der Poly-Silizium-Schicht werden weggeätzt. Auch dieser Vorschlag weist die Nachteile des in der DT-OS 27 23 374 geschilderten Verfahrens auf, mit dem Unterschied, daß die Böschungen der Poly-Silizium-Strukturen (und nicht der Kontaktlöcher) überhängend sein können.

Ein weiteres Verfahren wurde in einem Bericht von W. G. Oldham, M. Tormey: "Improved integrated circuit contact geometry using local oxidation", Electrochemical Society Spring Meeting, Seattle, USA, May 1978, p. 690 vorgeschlagen. Hier wird die oxidationshemmende Siliziumnitridschicht nach der Ätzung der Poly-Silizium-Schicht aufgebracht. Diese Nitridschicht wird so geätzt, daß sie nur dort, wo Kontaktlöcher entstehen sollen, stehenbleibt. Nachteilig an diesem Verfahren ist, daß die Böschungen der Poly-Silizium-Strukturen überhängend sein können und daß bei Kontaktlöchern, die ganz oder teilweise auf Gatebereichen angeordnet sind, die oben beschriebenen Sicherheitsabstände zu den Poly-Siliziumkanten erforderlich sind.

Ein Verfahren, welches die Sicherheitsabstände an der Peripherie der Kontaktlöcher zwischen einkristallinen n+-dotierten Bereichen und metallischen Leitbahnen zu verringern gestattet, bzw. überflüssig macht, ist aus der DT-OS 25 09 315 bekannt. Bei diesem Verfahren bringt man nach der Kontaktlochätzung Dotierstoff (Phosphor oder Arsen) in die Kontaktlöcher ein. Damit verhindert man bei überstehenden Kontaktlöchern einen Kurzschluß von den einkristallinen n+-Bereichen zu den benachbarten p-dotierten Bereichen. Die Sicherheitsabstände an der Peripherie der Kontaktlöcher zu den Poly-Silizium-Strukturen sind aber bei diesem Verfahren nach wie vor erforderlich.

Schließlich ist aus der DE-OS 27 04 626 ein Verfahren zur Bildung eines buried Kontaktes bekannt, bei dem die Dotierung der Kontaktzone im Substrat gleichzeitig mit der Dotierung der auf die Oberfläche des mit der Gateoxidschicht versehenen Substrates bei vorher geöffnetem Kontaktloch abgeschiedenen polykristallinen Siliziumschicht erfolgt. Hierbei besteht die Gefahr, daß bei der Öffnung des Kontaktloches eine Anätzung des Substrates stattfindet. Die genannten Sicherheitsabstände können ebenfalls nicht eingespart werden.

Die Aufgabe, die der vorliegenden Erfindung zugrundeliegt, besteht in der Herstellung einer MOS-Schaltung in Silizium-Gate-Technologie, bei der

1. die genannten Sicherheitsabstände überflüssig sind und daher eine große Packungsdichte der Schaltkreise pro Flächeneinheit möglich ist,

2. die Kurzschlüsse zwischen den über dem Kontaktloch anzubringenden metallischen Leitbahnen und den dazu benachbarten, im Silizium-Substrat erzeugten dotierten Bereichen vermieden werden und

3. die Oberfläche der Halbleiterschaltung möglichst eben ist und keine steilen Stufen aufweist.

Diese Aufgabe wird durch ein Verfahren der eingangs genannten Art mit den im Patentanspruch 1 angegebenen Verfahrensschritten a) bis o) gelöst.

Dabei sind die Verfahrensschritte zur Herstellung von strukturierten SiO$_2$-Schichten auf dem Halbleitersubstrat zur Trennung der aktiven Transistorbereiche, die Durchführung der Gate-Oxidation und die Abscheidung der ganzflächigen dotierten Polysiliziumschicht (Verfahrensschritte a), b) und c)) sowie die Durchführung der Ionenimplantation zur Erzeugung der Source- und Drainbereiche im Substrat (Verfahrensschritt f)) aus der DE-OS 27 04 626 bekannt; die Verfahrensschritte d), e) und h) bis m) weichen gegenüber dem bekannten Silizium-Gate-Prozeß ab.

Während bei dem in der DE-OS 27 04 626 beschriebenen Verfahren die Strukturierung der dotierten Polysiliziumschicht zur Bildung des buried-Kontaktes und des Gates vor der Erzeugung der Source/Drain-Zonen im Substrat erfolgt, wird beim Verfahren nach der Lehre der Erfindung das Gate vor der Erzeugung der Source/Drain-Zonen strukturiert und die dotierte Polysiliziumschicht zur Herstellung der Kontakte nach der Erzeugung der Source/Drain-Zonen dadurch gebildet, daß mit Hilfe einer Siliziumnitridmaskierung nur eine bereichsweise Umwandlung der ganzflächig aufgebrachten späteren Polysiliziumschicht in eine als Isolationsschicht dienende Siliziumoxidschicht durchgeführt wird.

In analoger Weise wie für den Silizium-Gate-Prozeß beschrieben, kann auch ein Doppel-Silizium-Gate-Prozeß (Si$^2$-Gate-Prozeß) nach dem erfindungsgemäßen Verfahren angewandt werden. In diesem Fall werden der Verfahrensschritt d) und die darauffolgenden Schritte nach dem Abscheiden der an sich bekannten zweiten Poly-Silizium-Gate-Schicht erfolgen.

Weitere Ausgestaltungen der Erfindung ergeben sich aus den Unteransprüchen.

Die wesentlichen Vorteile gegenüber den bekannten Verfahren sind folgende:

1. Bei gleicher Poly-Silizium-Dicke und gleicher Oxiddicke über den Poly-Silizium-Bereichen ist die Stufenhöhe an den Poly-Silizium-Flanken geringer.

2. Der Verlauf der Böschungen an den SiO$_2$-bedeckten-Poly-Silizium-Flanken ist günstiger in Bezug auf die Kantenbedeckung durch metallische Leitbahnen, da keine steilen oder negativen Flankenwinkel auftreten.

3. Es können auch relativ dicke (ca. 1 µm) SiO$_2$-Schichten über dem Poly-Silizium erzeugt werden.

4. Die SiO$_2$-Dicke zwischen den metallischen Leitbahnen und den einkristallinen n+-dotierten Bereichen ist größer.

5. Bei der Ätzung der Nitridschicht (Verfahrensschritt 1) kann man das Nitrid nicht nur an den Kontaktstellen, sondern auch überall dort stehen lassen, wo verbindende Poly-Silizium-Bahnen entstehen sollen. Damit gewinnt man eine zusätzliche Verdrahtungsebene. Die Poly-Silizium-Bahnen dieser Verdrahtungsebene dürfen darunterliegende Poly-Silizium-Bahnen sowie einkristalline n+- bzw. p+-dotierte Gebiete überkreuzen. Sie dürfen aber nicht durch Metallbahnen überkreuzt werden. Letzteres wäre nur dann zulässig, wenn man in Erweiterung des vorgeschlagenen Prozesses eine Isolationsschicht über den Poly-Silizium-Bahnen anbringen würde. Hierzu könnte man zum Beispiel wie bei den Prozeßschritten j) bis n) vorgehen.

6. Es wird ein neuartiger buried-Kontakt geschaffen, der gegenüber dem aus der DE-OS 27 04 626 bekannten buried-Kontakt sich wesentlich platzsparender und ohne Gefahr des Anätzens des Substrats gestalten läßt.

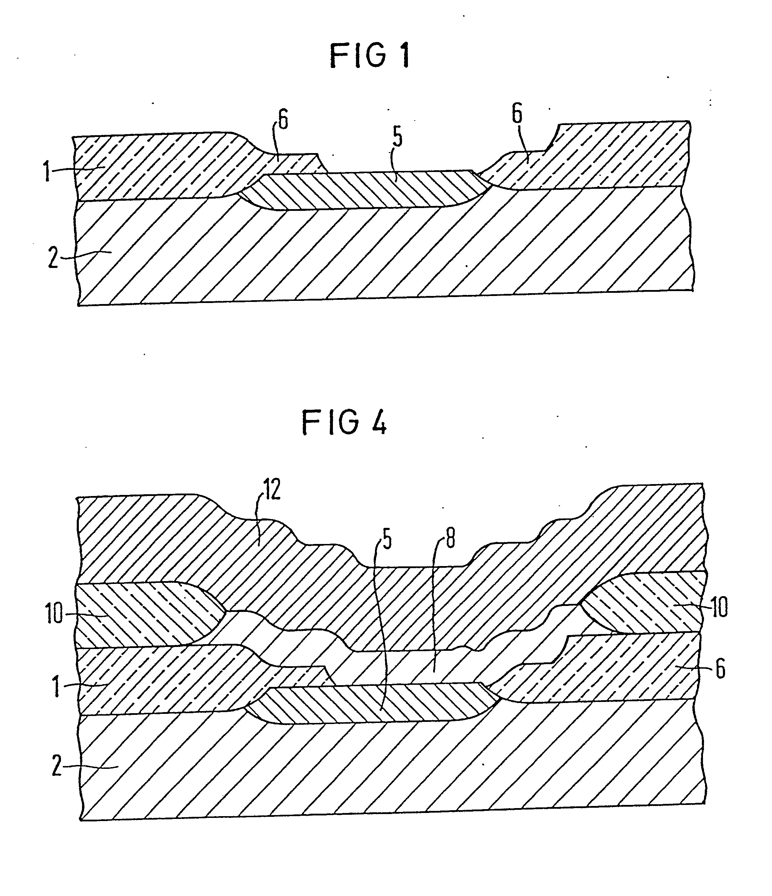

Weitere Einzelheiten und Vorteile der Erfindung werden anhand eines Ausführungsbeispiels in Form der Anwendung der Erfindung auf die n-Kanal-MOS-Technik und der Figuren 1 bis 6 noch näher beschrieben. Dabei zeigen die Figuren 1 bis 3 die verschiedenen, für die Erfindung wesentlichen Kontaktbereiche nach Verfahrensschritt i), wobei die

Figur 1 den Kontakt Leitbahn zu einkristallinem n+-dotiertem Gebiet darstellt, während die

Figur 2 den Kontakt Leitbahn zum Poly-Silizium und die

Figur 3 den Kontakt Poly-Silizium zu einkristallinem n+-dotierten Gebiet abbildet.

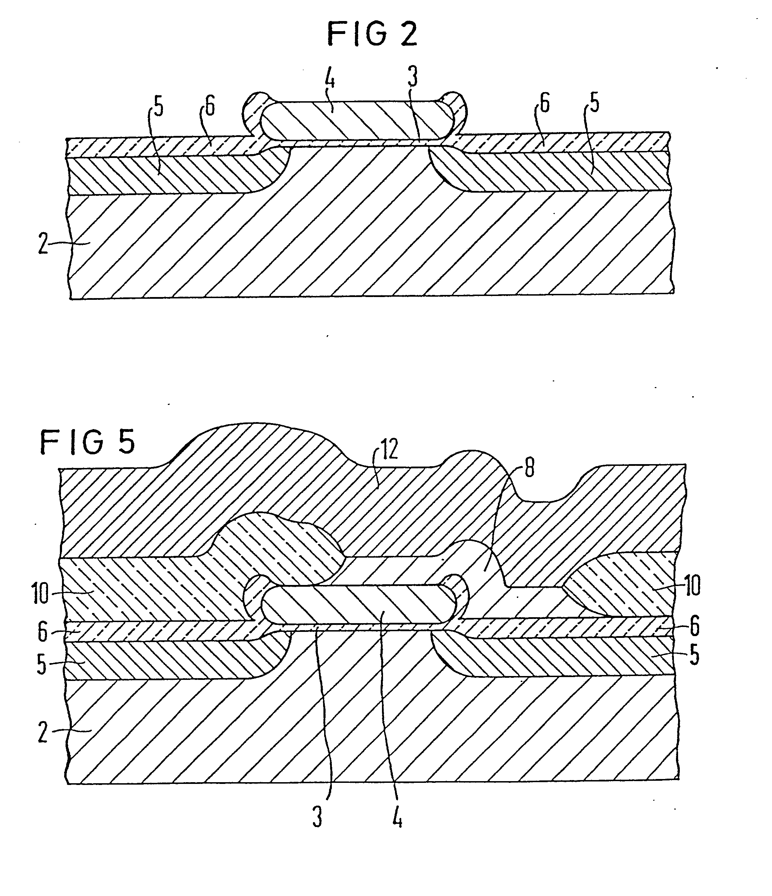

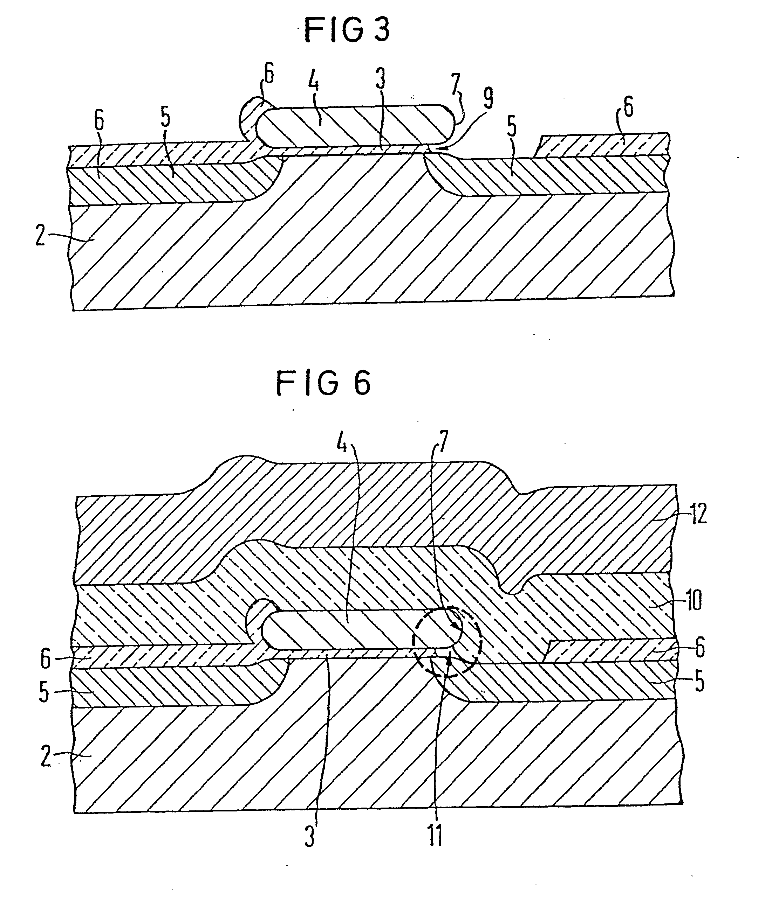

Die Figuren 3 bis 6 zeigen die verschiedenen Kontaktbereiche am Ende des Prozessablaufes, wobei die Figur 4 der Figur 1, die Figur 5 der Figur 2 und die Figur 6 der Figur 3 entspricht.

Der Prozeßablauf für einen Silizium-Gate-Prozeß in n-Kanal-MOS-Technik wird beispielsweise wie folgt durchgeführt:

a) Herstellen von strukturierten $SiO_2$-Schichten 1 (sogenannte Feldoxidbereiche ca. 0,6 µm dick) auf einem p-dotierten Halbleitersubstrat 2 zur Trennung der aktiven Transistorbereiche nach dem sogenannten LOCOS- oder Isoplanarverfahren (Figur 1),

b) Durchführung der Gateoxidation ($SiO_2$-Schicht 3 nach Figur 2) durch Aufoxidation der freien Substratoberflächen in einer Schichtdicke von 0,06 µm. Falls erwünscht kann Implantation der p- oder n-dotierenden Stoffen im Kanalbereich der Transistoren durchgeführt werden,

c) Abscheidung einer ganzflächigen ca. 0,4 µm dicken n+-dotierten ersten Poly-Silizium-Schicht 4 mit Hilfe eines Gasphasenabscheideverfahrens (Chemical Vapor Deposition = CVD-Verfahren) (Figur 2),

d) CVD-Abscheidung einer ganzflächigen 0,1 µm dicken Silizium-Nitrid-Schicht,

e) Ätzung der Silizium-Nitrid-Schicht und der ersten aufgebrachten Poly-Silizium-Schicht zur Erzeugung Nitridbedeckter Poly-Silizium-Bereiche,

f) Ionenimplantation (Arsen oder Phosphor) zur Erzeugung der einkristallinen n+-dotierten Source- und Drain-Bereiche 5 (Figur 1),

g) thermische Oxidation zur Erzeugung einer ca. 0,2 µm dicken $SiO_2$-Schicht 6 über den einkristallinen n+-dotierten Bereichen 5. Eine Oxidation der Poly-Silizium-Bereiche 4 wird (abgesehen von den Böschungsbereichen) durch die über der ersten aufgebrachten Poly-Silizium-Schicht 4 liegende Silizium-Nitrid-Schicht verhindert (Figur 2),

h) Entfernen der Nitridmaskierung,

i) Ätzung von Kontaktlöchern zur Ausbildung von Kontakten zwischen einkristallinen n+-dotierten Bereichen 5 einerseits und Poly-Silizium-Bereichen 4 (sogenannten buried-Kontakten) bzw. Metallbahnen 12 andererseits. Dabei entstehen im Bereich der buried-Kontakte unter Voraussezung eines isotropen Ätzangriffes überhängende Poly-Silizim-Ränder 7 (Figur 3),

j) CVD-Abscheidung einer weiteren n+-dotierten Poly-Silizium-Schicht 8 in einer Dicke im Bereich von 0,1 bis 0,5 µm. Dabei werden auch die "Höhlen" 9 unter den überhängenden Poly-Silizium-Rändern 7 (Figur 3) mit Poly-Silizium ausgefüllt,

k) CVD-Abscheidung einer ganzflächigen Silizium-Nitrid-Schicht in einer Schichtdicke von 0,1 µm,

l) Ätzung der Nitridschicht, ausgenommen an den Stellen, an denen Kontakte zu den metallischen Leitbahnen 12 entstehen sollen.

m) Umwandlung der später aufgebrachten Poly-Silizium-Schicht 8 in eine $SiO_2$-Schicht 10 durch thermische Oxidation. Die mit Nitrid bedeckten Teile der ersten aufgebrachten Poly-Silizium-Schicht 4 bleiben dabei unverändert. Da die thermische Oxidation beendet wird, sobald die später aufgebrachte Poly-Silizium-Schicht 8 in ihrer vollen Dicke in $SiO_2$ umgewandelt ist, bleibt im Bereich der Buried-Kontakte eine Poly-Silizium-Kontakt-Brücke 11 (in Figur 6 mit einer strichlierten Linie umrandet) zwischen dem einkristallinen n+-dotierten Bereich 5 und dem darüberstehenden Rand 7 des Poly-Silizium-Bereiches 4 bestehen. Diese Brücke 11 stellt einen neuartigen Buried-Kontakt dar, wie aus der Figur 6 deutlich zu ersehen ist,

n) Entfernen der Nitridmaskierung,

o) Erzeugung des metallischen Leitbahnmusters 12.

**Patentansprüche:**

1. Verfahren zum Herstellen von integrierten n- oder p-Kanal-MOS-Schaltungen in Silizium-Gate-Technologie mit selbstjustierten Kontakten mit folgenden Verfahrensschritten:

a) Herstellen von strukturierten $SiO_2$-Schichten (1) auf einem p- oder n-dotierten Halbleitersubstrat (2) zur Trennung der aktiven Transistorbereiche nach dem sogenannten LOCOS- oder Isoplanarverfahren,

b) Durchführung der Gate-Oxidation (3) durch Aufoxidieren der freien n- oder p-Substratoberflächen,

c) Abscheidung einer ganzflächigen n+- oder p+-dotierten ersten Poly-Silizium-Schicht (4),

d) Abscheidung einer ganzflächigen Silizium-Nitrid-Schicht,

e) Ätzung der Silizium-Nitrid- und der ersten aufgebrachten Poly-Silizium-Schicht (4) zur Erzeugung nitridbedeckter Poly-Silizium-Bereiche,

f) Durchführung einer Ionenimplantation zur Erzeugung einkristalliner n+- oder p+-dotierter Source- und Drainbereiche (5) im p- oder n-dotierten Silizium-Substrat (2),

g) Erzeugung einer $SiO_2$-Schicht (6) über den einkristallinen n+- oder p+-dotierten Bereichen (5) mittels einer thermischen Oxidation, wobei die Oxidation der Poly-Silizium-Bereiche (4) der ersten aufgebrachten Poly-Silizium-Schicht durch die über dem Poly-Silizium (4) liegende Silizium-Nitrid-Schicht verhindert wird,

h) Entfernen der Nitird-Maskierung,

i) Ätzung der Kontaktlöcher zur Ausbildung von Kontakten zwischen einkristallinen n+- oder p+-dotierten Bereichen (5) und den als Gateelektroden dienenden Poly-Silizium-Bereichen (4) (sogenannte Buried Kontakte), so daß im Bereich des freigelegten Poly-Siliziumrandes (9) wegen des isotropen Ätzangriffes unterätzte Poly-Silizium-Bereiche (7) entstehen,

j) Abscheidung einer ganzflächigen n+- oder p+-dotierten weiteren Poly-Silizium-Schicht (8) nach dem CVD-Verfahren, wobei auch die Bereiche (9) unter dem unterätzten Rand der Poly-Silizium-Bereiche (7) der zuerst aufgebrachten Poly-Silizium-Schicht (4) mit Poly-Silizium (8) ausgefüllt werden,

k) Abscheidung einer ganzflächigen Silizium-Nitrid-Schicht,

l) Ätzung der Silizium-Nitrid-Schicht, ausgenommen an den Stellen, an denen Kontakte zu den metallischen Leitbahnen (12) vorgesehen sind,

m) Umwandlung der freigelegten, später aufgebrachten Poly-Silizium-Schicht (8) in ihrer vollen Dicke in eine $SiO_2$-Schicht (10) durch thermische Oxidation, wobei die mit Nitrid bedeckten Teile der später aufgebrachten Poly-Silizium-Schicht (8) unverändert bleiben und wobei im Bereich der Buried-Kontakte (9) eine Poly-Silizium-Kontaktbrücke (11) zwischen den einkristallinen n+- oder p+-dotierten Bereichen (5) und dem unterätzten Rand (7) der ersten aufgebrachten Poly-Silizium-Schicht (4) gebildet wird,

n) Entfernen der Nitrid-Maske,

o) Herstellen des metallischen Leitbahnmusters (12).

2. Verfahren nach Anspruch 1, <u>dadurch gekennzeichnet</u>, daß in Abänderung des Verfahrens zur Durchführung eines $Si^2$-Gate-Prozesses die Verfahrensschritte d) bis o) nach der Abscheidung der an sich bekannten zweiten Poly-Silizium-Gate-Schicht durchgeführt werden.

3. Verfahren nach Anspruch 1, <u>dadurch gekennzeichnet</u>, daß die Schichtdicke der später aufgebrachten dotierten Poly-Silizium-Schicht (8) gemäß Verfahrensschritt j) auf einen Bereich von 0,1 bis 0,5 μm eingestellt wird.

4. Verfahren nach Anspruch 1, <u>dadurch gekennzeichnet</u>, daß die zur Maskierung verwendete Silizium-Nitrid-Schicht gemäß Vefahrensschritt k) in einer Schichtdicke von 0,1 μm hergestellt wird.


**Claims:**

1. A method for making integrated n- or p-channel-MOS-circuits by the silicon-gate technique with selfadjusting contacts, comprising the following process steps:

a) producing structured $SiO_2$-layers (1) on a p- or n-doped semiconductor substrate (2) in order to separate the active transistor regions in accordance with the so-called LOCOS- or isoplanar process,

b) carrying out the gate oxidation (3) by oxidizing the exposed n- or p-substrate surfaces,

c) depositing an n+- or p+-doped first polysilicon layer (4) over the whole surface,

d) depositing a silicon nitride layer over the whole surface,

e) etching the silicon nitride layer and the firstapplied polysilicon layer (4) to produce polysilicon regions which are covered with nitride,

f) carrying out an ion implantation to produce monocrystalline n+- or p+-doped source and drain zones (5) in the p- or n-doped silicon substrate (2),

g) producing an $SiO_2$-layer (6) over the monocrystaliine n+- or p+-doped regions (5) by a thermal oxidation, the oxidation of the polysilicon zones (4) of the first-applied polysilicon layer being prevented by the silicon nitride layer which is arranged above the polysilicon (4),

h) removal of the nitride masking,

i) etching contact apertures for the formation of contacts between monocrystálline n+- or p+-doped zones (5) and the polysilicon zones (4) which serve as gate electrodes (so-called buried contacts), so that underetched polysilicon zones (7) are formed in the region of the exposed polysilicon edge (9) as a result of the isotropic etching attack,

j) depositing an n+- or p+-doped further polysilicon layer (8) over the whole surface in accordance with the CVO-process, whereby the zones (9) below the underetched edge of the polysilicon zones (7) of the first-applied polysilicon layer (4) are filled with polysilicon (8),

k) depositing a silicon nitride layer over the whole surface,

l) etching the silicon nitride layer, except at the points at which contacts to the metal conductor paths (12) are arranged,

m) conversion of the exposed, second-applied polysilicon layer (8) over ita whole thickness into an $SiO_2$-layer (10) by thermal oxidation wherein the parts of the later-applied polyailicon layer (8) which are covered with nitride remain unchanged, and wherein, in the region of the buried contacts (9), a polyailicon contact bridge (11) ia formed between the monocrystalline n+- or p+-doped regions (5) and the underetched edge (7) of the first-applied polysilicon layer (4),

n) removal of the nitride mask,

o) production of the metal conductor path pattern (12).

2. A method as claimed in Claim 1, <u>characterised in</u> that as a modification of the process for carrying out an $Si^2$-gate process, the process steps d) to o) are carried out after the deposition of the polysilicon gate layer which is known <u>per se</u>.

3. A method as claimed in Claim 1, <u>characterised in</u> that the layer thickness of the later-applied doped polysilicon layer (8) is set in accordance with process step j) in the range of 0.1 to 0.5 μm.

4. A method as claimed in Claim 1, <u>characterised in</u> that the silicon nitride layer which is used for masking is produced in accordance with process k) in a layer thickness of 0.1 μm.


**Revendications**

1. Procédé pour la fabrication de circuits intégrés MOS à canal n ou p en technologie à grille au silicium avec des contacts auto-ajustables, avec les phases opératoires suivantes :

a) réalisation de couches structurées (1) en SiO$_2$ sur un substrat semiconducteur (2) dope en p ou en n en vue de séparer les zones actives de transistors selon le procédé dit LOCOS ou isoplanar,

b) réalisation de l'oxydation de grille (3) par oxydation des surfaces libres du substrat dopé en n ou en p,

c) dépôt d'une première couche à pleine surface em polysilicium (4) dopée en n+ ou en p+,

d) dépôt d'une couche à pleine surface de nitrure de silicium,

e) attaque de la couche de nitrure de silicium et de la couche en polysilicium (4) déposée en premier lieu, en vue de produire des zones de polysilicium recouvertes par du nitrure,

f) réalisation d'une implantation d'ions nour réaliser dans le substrat (2) dopé en p ou en n, des zones monocristallines de source et de drain (5), dopées en n+ ou en p+,

g) production d'une couche de SiO$_2$ (6) sur les zones monocristallines (5) dopées en n+ ou en p+ à l'aide d'une oxydation thermique, l'oxydation des zones en polysilicium (4) de la couche de polysilicium déposée en premier lieu par la couche de nitrure de silicium qui se situe au-dessus du polysilicium (4), étant empêchée,

h) suppression du masque de nitrure,

i) attaque des trous de contact pour la réalisation de contacts (appelés contacts ensevelis) entre des zones monocristallines (5) dopées en n+ ou em p+ et les zones en polysilicium (4) servant d'électrodes de grille, de maniére que se forment, dans la zone marginale de polysilicium (9) qui a été dégagée, des zones de polysilicium (7) sousattaquées, en raison de l'attaque isotrope,

j) dépôt d'une autre couche de polysilicium (8) à pleine surface et dopée en n+ ou en p+, selon le procédé CVD, les zones (9) qui sont situées endessous du bord sous-attaqué des zones de polysilicium (7) de la couche de polysilicium (4) qui a été déposée en premier lieu, étant egalement comblées avec du polysilicium (8),

k) dépôt d'une couche à pleine surface de nitrure de silicium,

l) attaque de la couche de nitrure de silicium, à l'exception des endroits auxquels sont prévus des contacts pour les pistes conductrices métalliques (12),

m) transformation de la couche de polysilicium (8) qui a été déposée ultérieurement et oui a été dégagée en une couche de SiO$_2$ (10) suivant son épaisseur totale, et par oxydation thermique, les parties de la couche de polysilicium (8) cui a été déposée ultérieurement et qui sont recouvertes avec du nitrure, restant inchangées, alors que dans la zone des contacts ensevelis (9) est formé un pont de contact de silicium (11) entre les zones monocristallines (5) dopées en n+ ou en p+ et le bord sous-attaqué (7) de la couche de polysilicium (4) qui a été déposée en premier lieu,

n) suppression du masque de nitrure,

o) réalisation du modéle de pistes conductrices métalliques (12).

2. Procédé selon la revendication 1, caractérisé par le fait qu'en variante du procédé pour la réalisation d'un processus de grille en Si$^2$, on ne réalise pas les phases opératoires d) à o), après le dépôt de la seconde couche, en soi connue, de grille en polysilicium.

3. Procédé selon la revendication 1, caractérisé par le fait que l'épaisseur de couche de la couche de polysilicium dopée (8) est déposée ultérieurement, selon la phase opératoire j), et réglée à une plage de 0,1 à 0,5 μm.

4. Procédé selon la revendication 1, caractérisé par le fait que la couche de nitrure de silicium utilisée, selon la phase opératoire k) pour le masquage, est réalisée avec une épaisseur de couche de 0,1 μm.

## FIG 1

## FIG 4

# FIG 2

# FIG 5

# FIG 3

# FIG 6